## Europäisches Patentamt
## European Patent Office
## Office européen des brevets

(11) Numéro de publication: **0 098 209**
**B1**

(12) # FASCICULE DE BREVET EUROPEEN

(45) Date de publication du fascicule du brevet:
**17.09.86**

(21) Numéro de dépôt: **83401285.8**

(22) Date de dépôt: **21.06.83**

(51) Int. Cl.⁴: **H 01 L 29/08,** H 01 L 29/10, H 01 L 29/52

(54) Transistor de commutation de puissance à structure digitée.

(30) Priorité: **25.06.82 FR 8211211**

(43) Date de publication de la demande:
**11.01.84 Bulletin 84/2**

(45) Mention de la délivrance du brevet:
**17.09.86 Bulletin 86/38**

(84) Etats contractants désignés:
**DE FR GB IT NL**

(56) Documents cités:
**EP - A - 0 019 355**
**DE - A - 2 802 799**
**US - A - 4 296 336**

(73) Titulaire: **THOMSON-CSF, 173, Boulevard Haussmann, F-75379 Paris Cedex 08 (FR)**

(72) Inventeur: **Arnould, Jacques, THOMSON-CSF SCPI 173, bld Haussmann, F-75379 Paris Cedex 08 (FR)**

(74) Mandataire: **Guérin, Michel et al, THOMSON-CSF SCPI 19, avenue de Messine, F-75008 Paris (FR)**

## Description

La présente invention concerne le domaine des transistors de commutation de puissance pour lesquels on cherche à obtenir une vitesse de commutation aussi élevée que possible. De façon classique, les électrodes d'émetteur et de base de tels transistors sont en forme de peignes interdigités, c'est-à-dire que l'électrode d'émetteur comprend des doigts allongés encadrés par des doigts de base.

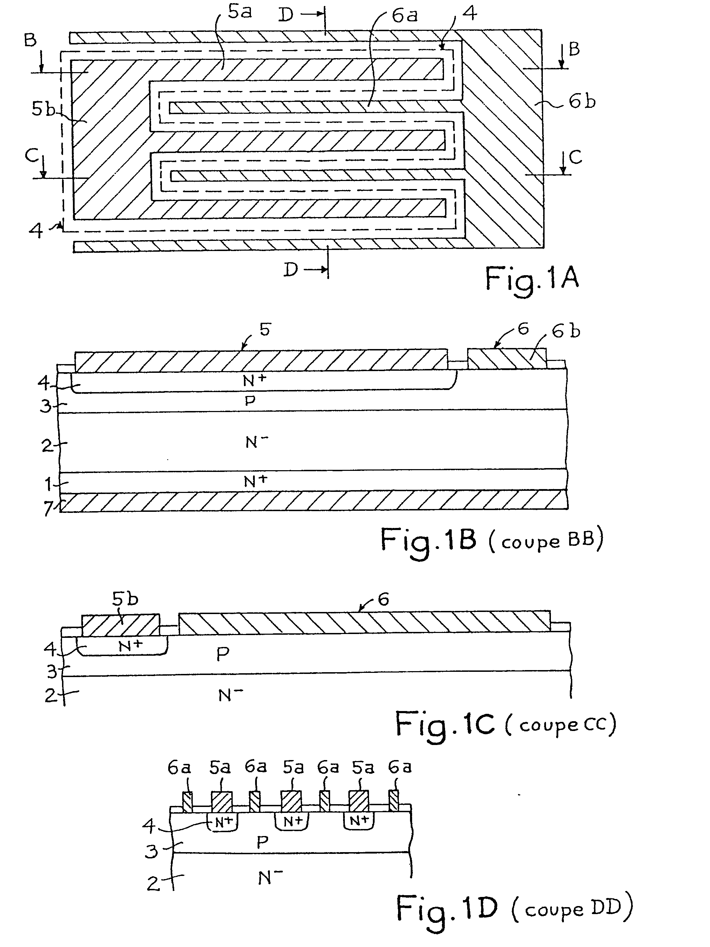

La figure 1A représente à titre d'exemple une vue de dessus d'une telle structure classique, les figures 1B, 1C et 1D représentant des vues en coupe selon les lignes B–B, C–C et D–D indiquées en figure 1A.

Comme le montre la figure 1B, un transistor de puissance classique comprend en partant de la face inférieure vers la face supérieure une couche 1 de type $N^+$ à fort niveau de dopage, une couche 2 de type $N^-$ à faible niveau de dopage, ces deux couches correspondant au collecteur du transistor, une couche 3 de type P ou couche de base, et une couche 4 de type $N^+$ occupant une partie de la surface de la couche 3 de type P. Cette couche 4 ou couche d'émetteur est revêtue d'une métallisation d'émetteur 5. Une métallisation de base est en contact avec une partie de la couche de base 3 et une métallisation de collecteur 7 est en contact avec la surface inférieure de la tranche semiconductrice.

En considérant la vue de dessus de la figure 1A et l'ensemble des vues en coupe des figures 1B, 1C et 1D, on peut voir dans la représentation schématique donnée à titre d'exemple que chaque métallisation d'émetteur 5 comprend des doigts 5a et au moins une zone élargie 5b. Cette zone 5b sert à connecter entre eux les divers doigts 5a et permet également d'assurer une liaison avec un fil de connexion soudé, généralement par ultra-sons ou par thermo-compression, sur cette zone. De même, l'électrode de base 6 comprend des doigts allongés 6a entrelacés avec les doigts d'émetteur et une zone élargie 6b. De façon classique, la zone d'émetteur 4 de type $N^+$ dont la frontière est représentée en pointillés en figure 1A a sensiblement le même contour que l'électrode d'émetteur 5.

On rappellera, comme cela est bien connu, que l'on emploie généralement, pour des transistors de commutation, des structures interdigitées présentant une longueur de jonction base-émetteur aussi grande que possible pour améliorer la rapidité de pasage à l'état bloqué du transistor. Les doigts utilisés doivent être aussi minces que possible pour éviter les phénomènes de focalisation des lignes de courant au moment du blocage. Neanmoins, les structures adoptées telles qu'illustrées en figure 1 n'éliminent pas aussi bien que cela serait souhaitable ces inconvénients étant donné la présence des zones élargies d'émetteur 5b et de base 6b.

Ainsi, un objet de la présente invention est de prévoir des transistor de puissance à structure interdigitée à commutation rapide dans lesquels l'influence sur le fonctionnement du transistor des zones élargies de contact d'émetteur et de base soit éliminée de façon à accroître les vitesses de commutation.

Pour atteindre cet objet, ainsi que d'autres, la présente invention prévoit un transistor de commutation de puissance comprenant des métallisations d'émetteur et de base interdigitées, chacune de ces métallisations comprenant une zone élargie destinées à permettre une prise de contact, dans lequel des régions d'émetteur disjointes sont formées dans le couche de base seulement sous les doigts de la métallisation d'émetteur, les dits doigts correspondant géométriquement auxdites régions d'émetteur disjointes, la zone élargie de la métallisation d'émetteur reposant sur une couche isolante sous laquelle se trouve une région semiconductrice de même type que la couche de base, mais disjointe de celle-ci, et située en surface de la couche du collecteur. Supplémentairement, la présente invention prévoit que la zone élargie de la métallisation de base repose au moins ponctuellement sur une couche semiconductrice de même type que les régions d'émetteur, mais disjointe de celle-ci. En outre, la partie centrale de chaque doigt de la métallisation de base pourra reposer sur une zone semiconductrice de même type que la région d'émetteur, mais disjointe de celle-ci, seules les parties latérales de chaque doigt étant en contact avec la couche de base.

Ces objets, caractéristiques et avantages ainsi que d'autres de la présente invention seront exposés plus en détail dans la description suivante de modes de réalisation particuliers faite en relation avec les figures jointes parmi lesquelles:

– les figures 1A à 1D sont des vues très schématiques d'un transistor à structure interdigitée de l'art antérieur et ont été décrites précédemment,

– les figures 2A à 2E sont une vue de dessus et diverses vues en coupe, partielles et très schématiques, destinées à illustrer divers aspects de la présente invention.

Dans ces diverses figures, aucune échelle n'est respectée, ni à l'intérieur d'une figure, ni d'une figure à l'autre. Bien au contraire, conformément à l'usage dans le domaine de la représentation des semiconducteurs, les diverses couches, régions et zones ont été arbitrairement dilatées ou réduites dans le seul but de faciliter la lisibilité des figures.

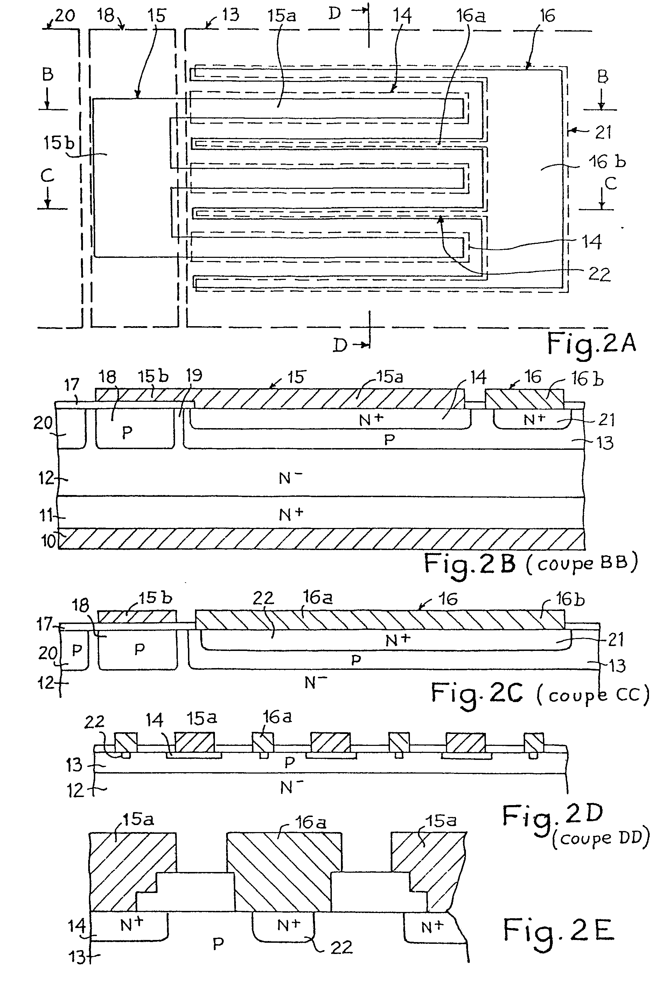

Comme le montre la vue en coupe de la figure 2B, la structure selon l'invention est élaborée sur un substrat comprenant une couche 11 de type $N^+$ et une couche 12 de même type de conductivité mais faiblement dopée dite $N^-$. La face inférieure de la couche $N^+$ est revêtue d'une métallisation de collecteur 10.

Contrairement au cas de la figure 1B, il n'existe plus au-dessus de la couche $N^-$ une couche de type P continue, mais cette couche est divisée en plusieurs régions disjointes. La région principale 13 correspond à la région de base du transistor dans laquelle sont diffusées des régions d'émetteur 14 de type $N^+$.

Dans la vue de dessus de la figure 2A, on a représenté des métallisation interdigitées d'émetteur 15 et de base 16 comprenant des doigts entrelacés 15a et 16a et des zones élargies de contact 15b et 16b. Selon un premier aspect de la présente invention, les zones d'émetteur 14 de type $N^+$ sont constituées de zones disjointes présentes seulement sous les doigts d'émetteur 15a. Les frontières de ces zones sont figurées en tiretés dans la figure 2A. La métallisation d'émetteur repose sur ces zones 14 au niveau des doigts 15a et est isolée de la couche semiconductrice sousjacente par une couche d'oxyde 17 sous la région élargie 15b (figures 2B et 2C). En outre, pour que cette couche d'oxyde 17 ne soit pas soumise à une tension importante et pour éviter que d'éventuels défauts dans cette couche produisent des court-circuits entre les zones de base et d'émetteur par contact entre la métallisation d'émetteur et la couche de base, cette couche de base 13 est interrompue sous la zone élargie 15b, sous laquelle se trouve une région de type P 18 disjointe de la région de base 13. On notera néanmoins que cette région 18 doit être aussi proche que possible de la région de base 13 pour permettre que la région intermédiaire 19 corresponde à une zone déserte dès que les tensions de fonctionnement du transistor sont établies. Dans ce même but, on a représenté en figures 2B et 2C, à la gauche de la région 18, une autre région 20 de type P disjointe des deux régions précédentes et remplissant en quelque sorte une fonction d'anneau de garde. En figure 2A, les limites des zones de type P, 13, 18 et 20 sont indiquées par des tiretés.

Selon un autre aspect de la présente invention, on cherche à éviter les zones mortes sous les métallisations de base, ces zones mortes constituant des diodes parasites collecteur/base qui consomment une partie du courant de base quand le transistor se trouve à l'état de saturation et qui accroissent la durée de passage du transistor de l'état conducteur à l'état bloqué. Pour ce faire, il est prévu, sous la partie élargie 16b de la métallisation de base 16, une zone diffusée de type $N^+$ 21. Dans la figure, cette zone $N^+$ est placée sous toute la métallisation de base sauf sous sa partie en regard des doigts d'émetteur. La zone 21 de type $N^+$ peut être interrompue par endroits, la couche de base 13 remontant au contact de la zone élargie 16b de la métallisation de base selon des lignes ou des points.

De même, la partie centrale de chacun des doigts de base, sensiblement sur toute leur longueur peut reposer sur une zone diffusée 22 de type $N^+$. La figure 2E qui représente de façon agrandie une partie de la vue en coupe selon D–D de la figure 2D, montre mieux comment est positionnée la diffusion 22 de type $N^+$ par rapport à un doigt de base 16a. A titre d'exemple numérique, si la distance entre deux doigts d'émetteur est de l'ordre de 150 microns, la largeur du doigt de base 16a, en contact avec la couche semiconductrice, peut être de l'ordre de 60 microns et la largeur de la zone diffusée 22 de type $N^+$ de l'ordre de 40 microns, le doigt de contact de base 16a étant ainsi en contact avec la couche de base de type P sur des largeurs de 10 microns à la gauche et à la droite de la région centrale 22.

La présente invention n'est pas limitée aux modes de réalisation qui ont été explicitement décrits ci-dessus. Elle en englobe les diverses variantes et généralisations incluses dans le domaine des revendications ci-après.

Notamment, les divers aspects de la présente invention pourront être utilisés séparément ou en combinaison, sur seulement une partie d'une structure de transistor ou sur tout un transistor, ou encore sur un transistor disposé dans une pastille semiconductrice comprenant d'autres composants élémentaires associés à ce transistor.

## Revendications

1. Transistor de commutation de puissance comprenant des métallisation d'émetteur (15) et de base (16) interdigitées, chacune de ces métallisations comportant une zone élargie (15b, 16b) destinée à permettre une prise de contact, caractérisé en ce que des régions d'émetteur disjointes (14) sont formées dans la couche de base (13) seulement sous les doigts (15a) de la métallisation d'émetteur, les dits doigts (15a) correspondant géométriquement auxdites régions d'émetteur disjointes (14), la zone élargie (15b) de la métallisation d'émetteur reposant sur une couche isolante (17) sous laquelle se trouve une région semiconductrice (18) de même type que la couche de base (13), mais disjointes de celle-ci, et située en surface de la couche du collecteur (12).

2. Transistor selon la revendication 1, caractérisé en ce que la distance entre les limites adjacentes de ladite région semiconductrice (18) et de la couche de base (13) est telle que, sous l'effet des tensions lorsque le transistor est en fonctionnement, la région intermédiaire (19) est désertée.

3. Transistor selon la revendication 1, caractérisé en ce que la zone élargie de la métallisation de base repose au moins partiellement sur une couche semiconductrice (21) de même type que les régions d'émetteur, mais disjointe de celle-ci.

4. Transistor selon la revendication 3, caractérisé en ce que ladite couche semiconductrice est interrompue ponctuellement ou linéairement par des remontées de la couche de base.

5. Transistor selon la revendication 3, caractérisé en ce que la partie centrale de chaque doigt de la métallisation de base repose sur une zone semiconductrice (22) de même type que les régions d'émetteur mais disjointe de celles-ci, seules les parties latérales de chaque doigt étant en contact avec la couche de base.

## Patentansprüche

1. Leistungs-Schalttransistor mit interdigital verschachtelten Emitter-(15) und Basis-(16)Metallisierungen, von denen jede eine verbreiterte Zone (15b, 16b) aufweist, welche dazu bestimmt ist, eine Kontaktierung zu gestatten, dadurch gekennzeichnet, dass getrennte Emittergebiete (14) in der Basisschicht (13) nur unter den Zinken (15a) der Emittermetallisierung gebildet sind, wobei die genannten Zinken (15a) geometrisch den genannten getrennten Emittergebieten (14) entsprechen, wobei die verbreiterte Zone (15b) der Emittermetallisierung auf einer Isolierschicht (17) ruht, unter welcher sich ein Halbleitergebiet (18) gleichen Typs wie die Basisschicht (13) befindet, jedoch von dieser getrennt ist sowie an der Oberfläche der Kollektorschicht (12) liegt.

2. Transistor nach Anspruch 1, dadurch gekennzeichnet, dass der Abstand zwischen den einander benachbarten Grenzen des genannten Halbleitergebietes (18) und der Basisschicht (13) derart ist, dass unter der Wirkung der Spannungen im Betrieb des Transistors das Zwischengebiet (19) verarmt ist.

3. Transistor nach Anspruch 1, dadurch gekennzeichnet, dass die verbreiterte Zone der Basismetallisierung wenigstens teilweise auf einer Halbleiterschicht (21) gleichen Typs wie die Emittergebiete, die jedoch von diesen getrennt ist, ruht.

4. Transistor nach Anspruch 3, dadurch gekennzeichnet, dass die Halbleiterschicht punktförmig oder linienförmig durch Hochführungen der Basisschicht unterbrochen ist.

5. Transistor nach Anspruch 3, dadurch gekennzeichnet, dass der mittlere Teil jedes Zinkens der Basismetallisierung auf einer Halbleiterzone (22) gleichen Typs wie die Emittergebiete, die jedoch von diesen getrennt ist, ruht, wobei nur die Seitenteile jedes Zinkens in Berührung mit der Basisschicht sind.

### Claims

1. Power switching transistor comprising interdigitated emitter (15) and base (16) metallizations, each of these metallizations comprising an enlarged zone (15b, 16b) intended for contacting, characterized in that disjoint emitter regions (14) are formed in the base layer (13) only beneath the fingers (15a) of the emitter metallization, said fingers (15a) geometrically corresponding to said disjoint emitter regions (14), the enlarged zone (15b) of the emitter metallization lying on an insulating layer (17) beneath which a semiconductor region (18) of the same type as the base layer (13), but disjoint therefrom, is provided which is located at the surface of the collector layer (12).

2. Transistor according to claim 1, characterized in that the distance between the adjacent limits of said semiconductor region (18) and the base layer (13) is such that the intermediate region (19) is depleted under the action of the voltages when the transistor is operating.

3. Transistor according to claim 1, characterized in that the enlarged zone of the base metallization lies at least partially on a semiconductor layer (21) of the same type as the emitter regions, but disjoint therefrom.

4. Transistor according to claim 3, characterized in that said semiconductor layer is punctually or linearly interrupted by upward extensions of the base layer.

5. Transistor according to claim 3, characterized in that the central part of each finger of the base metallization lies on a semiconductor layer (22) of the same type as the emitter regions, but disjoint therefrom, only the lateral portions of each finger contacting the base layer.

Fig.1A

Fig.1B (coupe BB)

Fig.1C (coupe CC)

Fig.1D (coupe DD)

2/2

Fig.2A

Fig.2B (coupe BB)

Fig.2C (coupe CC)

Fig.2D (coupe DD)

Fig.2E